(19) **Europäisches Patentamt European Patent Office Office européen des brevets**

(11) **EP 4 717 664 A1**

(12) **EUROPEAN PATENT APPLICATION**

(43) Date of publication:
01.04.2026 Bulletin 2026/14

(21) Application number: 24203229.0

(22) Date of filing: **27.09.2024**

(51) International Patent Classification (IPC):
*B81C 1/00* (2006.01)    *H04R 19/00* (2006.01)

(52) Cooperative Patent Classification (CPC):
**B81C 1/00238; B81C 1/00888; H04R 19/005;**
B81B 2201/0257; B81B 2201/0264; B81B 2207/012;
B81C 2203/0792

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Infineon Technologies AG**
**85579 Neubiberg (DE)**

(72) Inventors:
• **AHRENS, Carsten**
**93059 Regensburg (DE)**

• **LOHNINGER, Gerhard**
**81825 München (DE)**
• **STRASSER, Johann**
**84069 Schierling (DE)**
• **THALMAYR, Florian**
**85630 Grasbrunn (DE)**

(74) Representative: **Fischer, Florian**
**Schoppe, Zimmermann, Stöckeler,**
**Zinkler, Schenk & Partner mbB**
**Patentanwälte**
**Radlkoferstraße 2**
**81373 München (DE)**

(54) **MEMS PRESSURE TRANSDUCER WAFER-LEVEL CHIP-SCALE PACKAGE AND METHOD FOR PRODUCING THE SAME**

(57)    The present disclosure concerns a MEMS pressure transducer Wafer-Level Chip-Scale Package (100) and a method for manufacturing the same. The method comprises a step of providing a MEMS wafer (110) comprising a plurality of adjacently arranged MEMS membrane structures (120). The method comprises a further step of providing an ASIC wafer (210) comprising a plurality of adjacently arranged integrated electronic components (220), and bonding the MEMS wafer (110) with the ASIC wafer (210) with their respective front sides (111, 211) facing each other. The method comprises a further step of structuring at least one first cavity (150) into MEMS wafer (110) and structuring a smaller second cavity (160) into the first cavity (150).

Fig. 3

EP 4 717 664 A1

**Description**

Embodiments of the present disclosure relate to packaging concepts for MEMS devices (MEMS: Micro Electro Mechanical System), and in particular for MEMS pressure transducer devices, such as, for instance, ambient pressure sensors, microphones, speakers or the like. The herein disclosed innovative packaging concept concerns a wafer-level chip-scale package (WLCSP) for a MEMS pressure transducer device and a method for producing the same.

Today's silicon MEMS pressure transducer packages include several structural parts like MEMS, ASIC, Integrated-Passive-Device (IPD), Environmental-barrier (EB), lid. All of these single parts have to be assembled into modules on a multilayer laminate with classical die-attach and wirebond in a serial process. This process, however, has a complex supply chain, relatively high cost and results in a large footprint of the assembled package.

Therefore, it would be desirable to provide a MEMS pressure transducer package and a corresponding manufacturing process for the same that results in a compact design with significantly smaller footprint, high yield, and cheap parallel processing. This can be achieved by the MEMS pressure transducer package and its manufacturing process according to the independent claims.

The innovative manufacturing method provides for assembling all structural components of a pressure transducer package in a waferlevel process by using waferbonding, wherein dicing is reduced to only one time instead of dicing each single die. The method makes use of Wafer-level packaging (WLP), which is a process in integrated circuit manufacturing where packaging components are attached to an integrated circuit (IC) before the wafer - on which the IC is fabricated - is diced. In WLP, the top and bottom layers of the packaging and the solder bumps are attached to the integrated circuits while they are still in the wafer. This process differs from a conventional process, in which the wafer is sliced into individual circuits (dice) before the packaging components are attached.

WLP is essentially a true chip-scale package (CSP) technology, since the resulting package is practically of the same size as the die. Wafer-level packaging allows integration of wafer fab, packaging, test, and burn-in at wafer level in order to streamline the manufacturing process undergone by a device from silicon start to customer shipment.

Wafer-level chip scale packaging (WLCSP) is the smallest package. A WLCSP package is just a bare die with a redistribution layer (RDL, interposer or I/O pitch) to rearrange the pins or contacts on the die so that they can be big enough and have sufficient spacing so that they can be handled just like a ball grid array (BGA) package. The RDL is often made out of a polyamide or polybenzoxazole with copper plated on its surface.

Accordingly, the herein disclosed innovative approach concerns the manufacturing of a MEMS pressure transducer Wafer-Level Chip-Scale Package. The method comprises a step of providing a MEMS wafer having a front side and an opposite back side, the front side comprising a plurality of adjacently arranged MEMS membrane structures being embedded in an embedding material layer. The method further comprises a step of providing an ASIC wafer having a front side and an opposite back side, the front side comprising a plurality of adjacently arranged integrated electronic components for transducing a membrane oscillation into an electric signal. The MEMS wafer is bonded with the ASIC wafer with their respective front sides facing each other. The method further comprises a step of structuring at least one first cavity into the backside of the MEMS wafer and structuring a smaller second cavity inside the first cavity, said smaller second cavity being positioned opposite of at least one of the plurality of adjacently arranged MEMS membrane structure. The method further comprises a step of releasing said at least one MEMS membrane structure by removing the embedding material layer through the second cavity and bonding a lid wafer onto the back side of the MEMS wafer for covering the first cavity. Then, the MEMS pressure transducer Wafer-Level Chip-Scale Package is singulated by dicing around the covered first cavity.

The innovative concept further concerns a MEMS pressure transducer Wafer-Level Chip-Scale Package being obtainable by the above described innovative method. The MEMS pressure transducer Wafer-Level Package comprises a substrate stack comprising a MEMS substrate and an ASIC substrate, wherein the MEMS substrate has a front side and an opposite back side, wherein at least one MEMS membrane structure is provided at the front side. The ASIC substrate also has a front side and an opposite back side, the front side comprising at least one integrated electronic component for transducing an oscillation of the MEMS membrane structure into an electric signal. The MEMS substrate and the ASIC substrate are stacked with their respective front sides facing each other. The MEMS pressure transducer Wafer-Level Chip-Scale Package comprises a first cavity provided in the backside of the MEMS substrate and a smaller second cavity being located between the first cavity and the front side of the MEMS substrate, wherein the MEMS membrane structure is provided atop or inside said smaller second cavity, and a lid being bonded onto the backside of the MEMS substrate for covering the first cavity.

Further advantageous embodiments are described in the appended dependent claims.

In the following, embodiments of the present disclosure are described in more detail with reference to the figures, in which

Fig. 1A        shows a schematic overview of structural components that need to be integrated into a MEMS device package,

Fig. 1B        shows a schematic view of integrating the structural components according to Figure 1A into a conventional package,

Figs. 2A-2H    show a structural description of single method steps of an innovative method for manufacturing a MEMS pressure transducer wafer-level chip-scale package,

Fig. 3         show a schematic side view of a singulated MEMS pressure transducer wafer-level chip-scale package according to an embodiment,

Fig. 4         show a schematic side view of a singulated MEMS pressure transducer wafer-level chip-scale package according to a further embodiment,

Fig. 5         show a schematic side view of a singulated MEMS pressure transducer wafer-level chip-scale package according to a further embodiment, and

Figs. 6A-6B    show a top view and a side view of a singulated MEMS pressure transducer wafer-level chip-scale package for calculating its back volume.

_DESCRIPTION OF THE FIGURES_

Equal or equivalent elements or elements with equal or equivalent functionality are denoted in the following description by equal or equivalent reference numerals.

Method steps which are depicted by means of a block diagram and which are described with reference to said block diagram may also be executed in an order different from the depicted and/or described order. Furthermore, method steps concerning a particular feature of a device may be replaceable with said feature of said device, and the other way around.

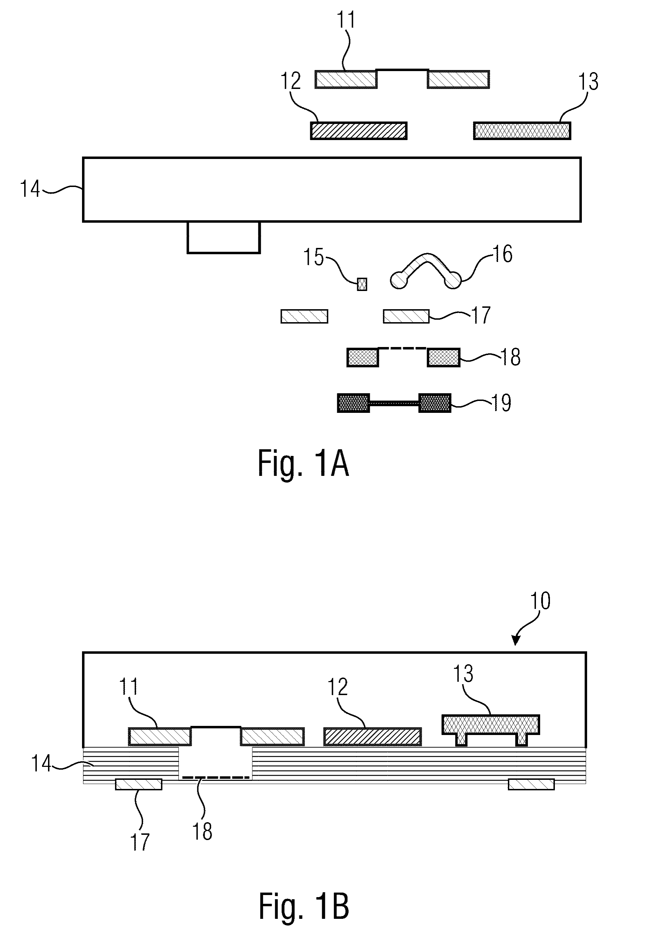

For a brief introduction, Figures 1A and 1B show a conventional MEMS device package 10, wherein all structural components have to be assembled individually. For example, the conventional MEMS device package 10 may comprise one or more of the following components: the MEMS device 11 itself, an ASIC 12, one or more integrated passive devices 13, a substrate 14 with a port, chiplet interconnects 15 and bond wires 16, solder pads 17, a particle mesh 18 and an environmental barrier 19.

As mentioned above, all of these single structural parts 11, ..., 19 have to be assembled into modules 10 on a multilayer laminate with classical die-attach and wire bond in a serial process. This process, however, has a complex supply chain, relatively high cost and results in a large footprint of the assembled package 10.

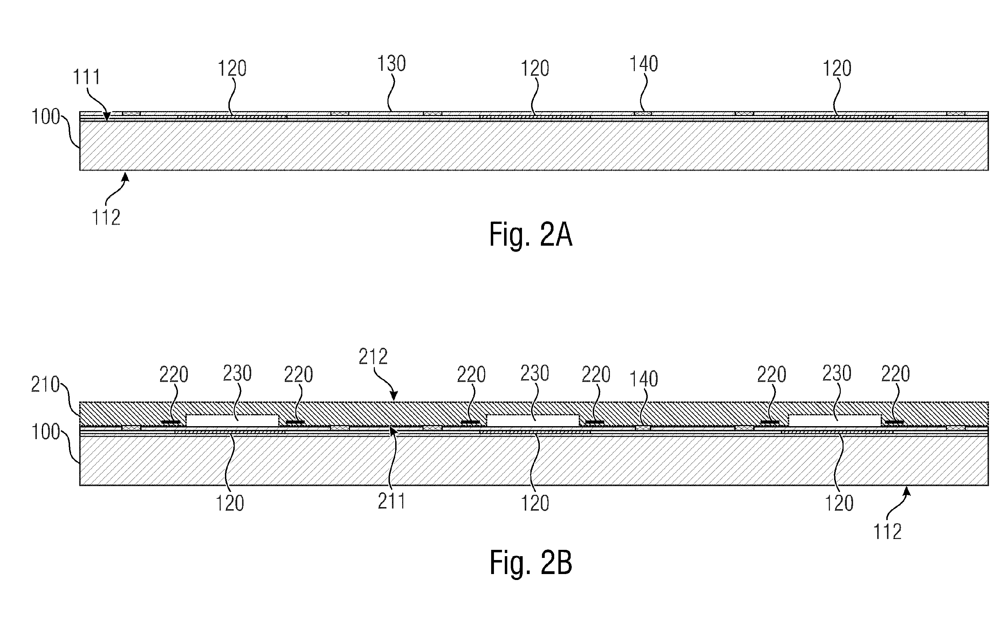

Thus, the herein described innovative concept provides a solution by integrating all of the structural components on wafer level prior to singulating the individual packages. The innovative method will be structurally described in the following with reference to Figures 2A to 2H showing structural portions of the MEMS pressure transducer Wafer-Level Chip-Scale Package for explaining the innovative method.

Thus, although some aspects will be described in the context of a device, it is clear that these aspects also represent a description of the corresponding method, where a block or device corresponds to a method step or a feature of a method step. Analogously, aspects described in the context of a method step also represent a description of a corresponding block or item or feature of a corresponding device.

Figure 2A shows a first method step, in which a MEMS wafer 110 is provided. The MEMS wafer 110 has a front side 111 and an opposite back side 112. On the front side 111, a plurality of adjacently arranged MEMS membrane structures 120 are arranged. Adjacently arranged in the sense of the present disclosure means that the MEMS membrane structures 120 are positioned adjacent to each other in a lateral (e.g., horizontal) direction. The MEMS membrane structures 120 may be embedded in an embedding material layer 130 for ease of manufacturing. The MEMS membrane structures 120 may be configured as so-called sealed dual membrane structures.

A metallization 140 may be provided on the front side 111 of the MEMS wafer 110, for example on an exposed surface of the embedding material layer 130. The metallization 140 may be provided in the form of a structured metallization layer 140. Depending on the thickness of the metallization 140, it may provide a standoff region to the MEMS membrane structure 120 after bonding in the next step.

Figure 2B shows a further method step, in which an ASIC wafer 210 is provided. The ASIC wafer has a front side 211 and an opposite back side 212. The back side 212 of the ASIC wafer 210 may optionally be grinded for thinning the ASIC wafer 210.

On the front side 211 of the ASIC wafer 210, a plurality of adjacently arranged integrated electronic components 220 are arranged. Adjacently arranged in the sense of the present disclosure means that the integrated electronic components 220 are positioned adjacent to each other in a lateral (e.g., horizontal) direction. The integrated electronic components 220 may be used for transducing a membrane oscillation into an electric signal. For example, the integrated electronic component 220 may be a first amplifier transistor.

A plurality of additional electronic components (not explicitly shown) may be provided in the ASIC wafer 210 for creating an integrated circuit structure as a controller unit for controlling the behavior of the MEMS pressure transducer device.

Prior to bonding the ASIC wafer 210 with the MEMS wafer 110, a plurality of adjacently arranged cavities 230 may be structured into the front side 211 of the ASIC wafer 210. Then, the ASIC wafer 210 and the MEMS wafer 110 are bonded with each other, such that their respective front sides 111, 211 face each other. In particular, the ASIC wafer 210 and the MEMS wafer 110 are bonded such that the cavities 230 are positioned opposite to the MEMS membrane structures 120. As will be explained in more detail below, the cavities 230 may allow the MEMS membrane structures 120 to freely oscillate when being deflected into the direction of the ASIC substrate 210.

The present innovative approach of bonding the MEMS wafer 110 and the ASIC wafer 210 with their respective front sides 111, 211 facing each other allows for positioning the integrated electronic components 220 in direct vicinity to the MEMS membrane structures 120. In particular, at least one integrated electronic component 220 may be located in direct vicinity of at least one MEMS membrane structure 120. As will be explained in more detail below, extremely short connection lines may be provided between the at least one integrated electronic component 220 and the at least one MEMS membrane structure 120 resulting in significantly less crosstalk and a higher SNR (Signal-to-Noise Ratio).

According to an embodiment, the MEMS wafer 110 and the ASIC wafer 210 may be bonded by applying a hybrid bonding technique using a copper metallization. Hybrid bonding is a permanent bond that combines a dielectric bond (SiOx) with embedded metal (Cu) to form interconnections. It may also be referred to as direct bond interconnect (DBI). Hybrid bonding extends fusion bonding with embedded metal pads in the bond interface, which allows face-to-face connection of the wafers. A hybrid bond may provide a hermetic seal between the ASIC wafer 210 and the MEMS wafer 110.

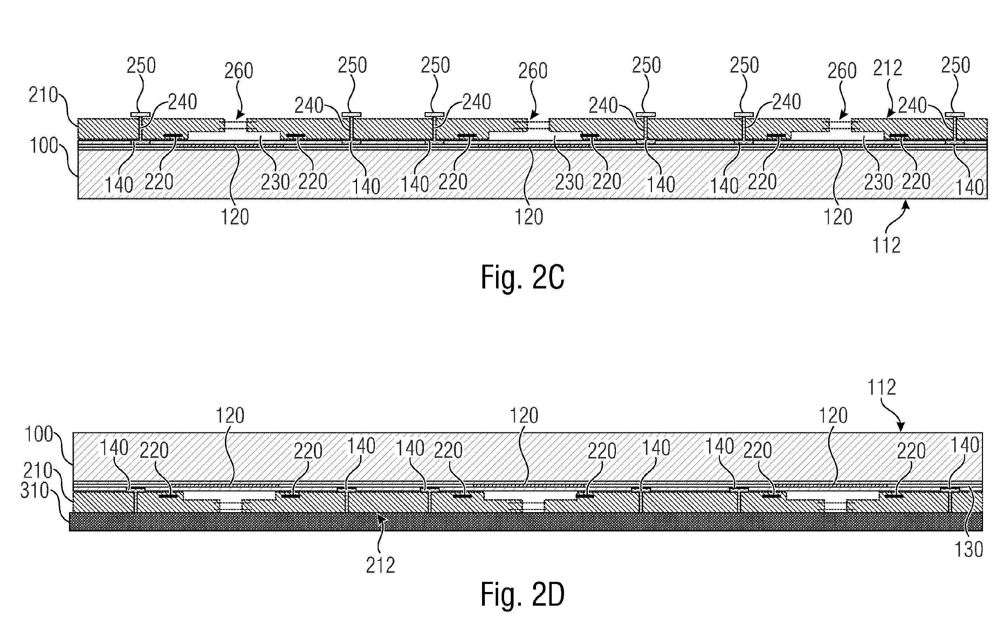

Figure 2C shows a further method step, in which a plurality of through-substrate vias (TSV) 240 may be created in the ASIC substrate 210. A through-substrate via 240 may extend between the metallization 140 arranged between the ASIC Wafer 210 and the MEMS wafer 110 and a bond pad 250 provided on the back side 212 of the ASIC Wafer 210. The bond pad 250 can be contacted from the outside for providing an electric connection to the integrated electronic components 220, which may be galvanically connected to the metallization 140. The through-substrate vias (TSV) 240 and/or the bond pads 250 may be created in a so-called post bond step, i.e., after bonding the MEMS wafer 110 with the ASIC substrate 210.

A plurality of adjacently arranged openings 260 may be structured into the back side 212 of the ASIC Wafer 210. The openings 260 may be structured into the back side 212 of the ASIC wafer 210 after bonding the ASIC wafer 210 with the MEMS wafer 110, as exemplarily shown in Figure 2C, or prior to bonding. Each opening 260 extends into one cavity 230 for providing a port to the environment of the (later) singulated MEMS pressure transducer Wafer-Level Chip-Scale Package (WLCSP). For example, in case the MEMS pressure transducer WLCSP is provided as a MEMS microphone WLCSP, the opening 260 may be configured as a sound port for allowing sound waves to pass through.

Figure 2D shows a further method step, in which the ASIC substrate 210 and the MEMS wafer 110 are flipped, i.e., turned around by 180°. Optionally, a carrier 310 may be provided for ease of wafer handling. The carrier 310 may be attached to the back side 212 of the ASIC substrate 210.

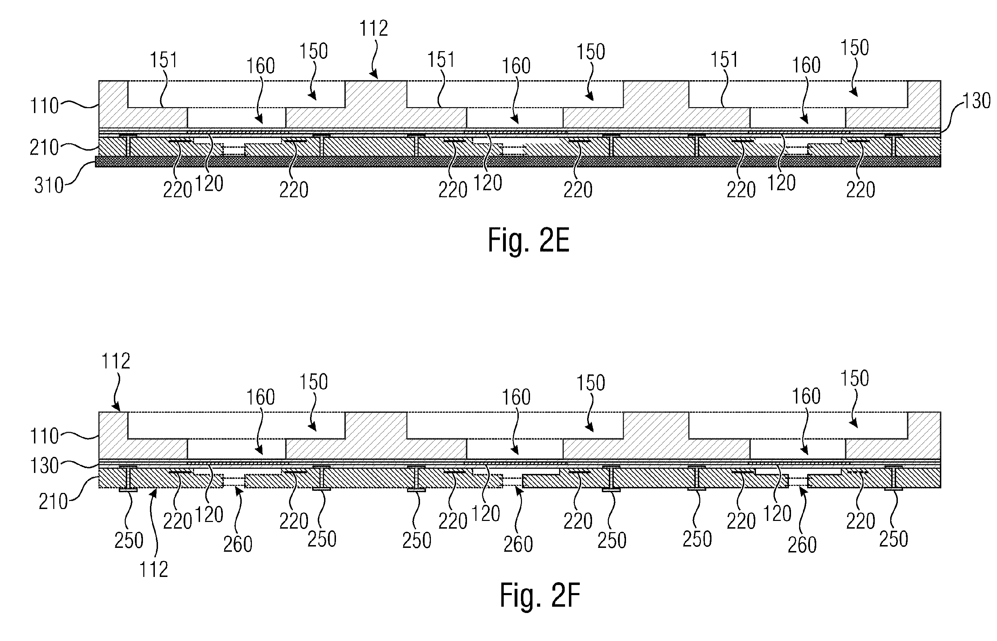

Figure 2E shows a further method step, in which a plurality of adjacently arranged first cavities 150 are structured into the backside 112 of the MEMS wafer 110. Each first cavity 150 is positioned (vertically) opposite to one of the MEMS membrane structures 120. Additionally, in a so-called two-step cavity etch a smaller second cavity 160 is structured into the first cavity 150. Each second cavity 160 is positioned (vertically) opposite to one of the MEMS membrane structures 120.

In particular, the first cavity 150 may be structured with a predefined depth into the MEMS wafer 110 such that a bottom portion 151 of the first cavity 150 is created inside the MEMS wafer 110. The above mentioned smaller second cavity 160 is then structured into said bottom portion 151 of the larger first cavity 150. The terms smaller and larger refer to the lateral extensions of the cavities 150, 160, such as their length, width or diameter (in case of circular cavities).

Figure 2F shows a further method step, in which the MEMS membrane structures 120 are released by removing the embedding material layer 130 through the second cavity 160. The embedding material layer 130 may be removed by wet or dry etching, e.g., by a so-called release etch step, wherein the etchant may be provided through the cavities 150, 160. The released MEMS membrane structures 120 may freely oscillate in response to impinging pressure waves, such as sound waves, travelling through the port 260.

According to an embodiment, the second cavity 160 may comprise lateral dimensions (e.g., length, width, diameter, etc.) being substantially equal to the lateral dimensions of the corresponding MEMS membrane structure 120, such that the MEMS membrane structure 120 may fit into the second cavity 160 when being deflected. As will be explained in more detail below, in case of the MEMS pressure transducer WLCSP being configured as a MEMS microphone WLCSP, the first cavity 150 and the second cavity 160 may together define a back volume.

Optionally in the method step according to Figure 2F, the aforementioned carrier 310 may be removed so as to expose the pads 250.

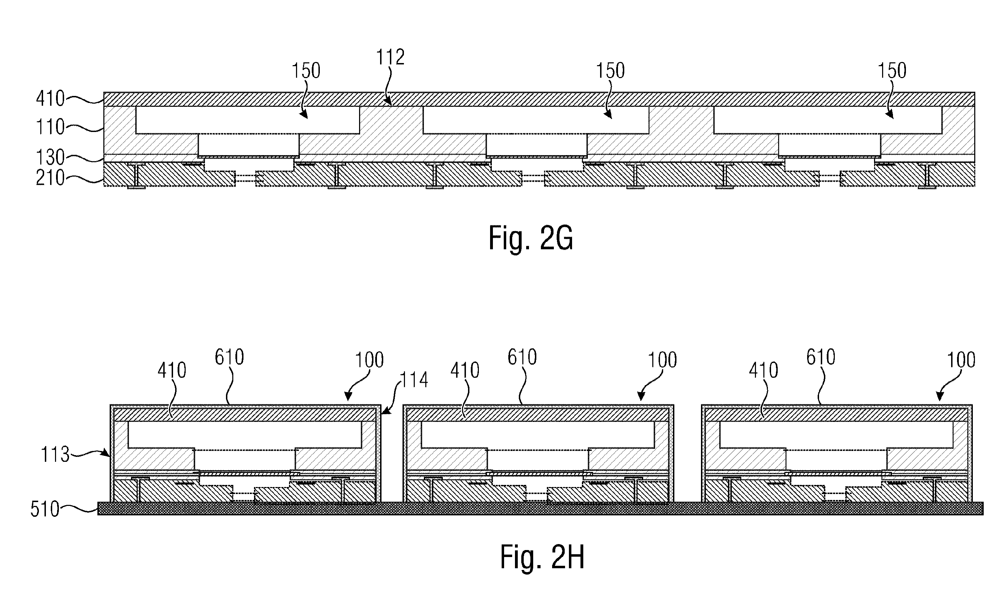

Figure 2G shows a further method step, in which a lid wafer 410 is bonded onto the back side 112 of the MEMS wafer 110 for covering the first cavity 150. A tape 510 may be applied to the back side 212 of the ASIC wafer 210 for handling the wafer stack upon singulating the MEMS pressure transducer Wafer-Level Chip-Scale Packages 100 in a next method step.

Figure 2H shows said further method step, in which a plurality of MEMS pressure transducer Wafer-Level Chip-Scale Packages 100 are singulated by dicing around each of the covered first cavities 150. For example, stealth dicing may be applied as a singulation process. As can be seen, each MEMS pressure transducer Wafer-Level Chip-Scale Packages 100 may comprise a wafer stack comprising at least a MEMS wafer 110, an ASIC wafer 210 and a lid wafer 410.

It shall be noted that the process of manufacturing the MEMS pressure transducer Wafer-Level Chip-Scale Packages 100, as discussed with reference to Figures 2A to 2G, is performed on wafer level, i.e., a MEMS wafer 110 and an ASIC wafer 210 were processed. After singulating the single MEMS pressure transducer Wafer-Level Chip-Scale Packages 100, individual packages are obtained from the wafer. Thus, the previously termed MEMS wafer 110 becomes a MEMS substrate 110, and the previously termed ASIC wafer 120 becomes an ASIC substrate 120. However, for ease of understanding, the terms MEMS wafer and MEMS substrate, as well as the terms ASIC wafer and ASIC substrate, may be used synonymously within the present disclosure.

Optionally, an electrically conductive coating 610 may be applied onto the MEMS pressure transducer Wafer-Level Chip-Scale Packages 100 after singulating them. Said electrically conductive coating 610 may cover the entire singulated MEMS pressure transducer Wafer-Level Chip-Scale Package 100 with the exception of the back side 212 of the ASIC substrate 210. In other words, the lid 410 as well as lateral outer side walls 113, 114 of the MEMS pressure transducer Wafer-Level Chip-Scale Packages 100 may be coated. The electrically conductive coating 610 may be grounded for providing a radio frequency (RF) shielding.

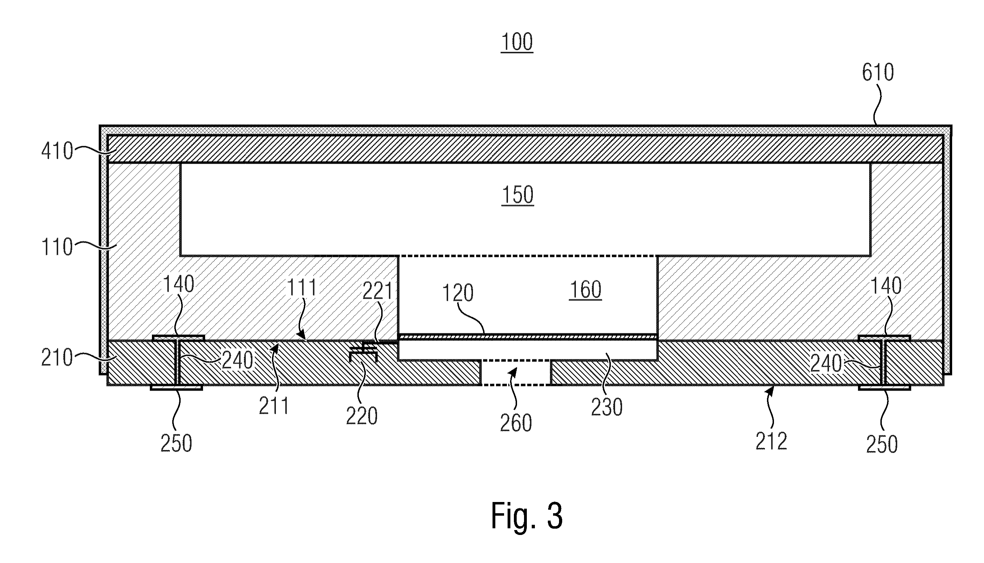

Figure 3 shows a single Wafer-Level Chip-Scale Package 100 that was produced according to the above described innovative method. Features with like structures and/or functions are labelled with like reference numerals.

As can be seen, the aforementioned integrated electronic component 220, e.g., a first amplifier transistor, is located laterally adjacent to the MEMS membrane structure 120. The integrated electronic component 220 is integrated in the front side 212 of the ASIC substrate 210. The integrated electronic component 220 may be galvanically connected at the frontside 211 of the ASIC substrate 210 to the MEMS membrane structure 120. For example, a metallic connection 221 may be provided for galvanically connecting the integrated electronic component 220 to the MEMS membrane structure 120. The metallic connection 221 may be configured as a metallic redistribution layer inside the ASIC substrate 210.

This differentiates the herein disclosed innovative approach from other conventional WLCSP, in which the ASIC substrate is bonded with its back side to the MEMS substrate. In this case, the front side of the ASIC substrate would face away from the MEMS substrate and, thus, the first amplifier transistor being integrated in the front side of the ASIC substrate would also face away from the MEMS substrate. As a consequence, a through-substrate-via has to be provided for electrically connecting the first amplifier transistor with the MEMS membrane structure.

However, any physical electric connections between the first amplifier transistor 220 and the MEMS membrane structure 120 may act as a parasitic capacitance being prone to undesired RF influences. As mentioned above, the present innovative concept suggests bonding the ASIC wafer 210 and the MEMS wafer 110 with their respective front sides 111, 211 facing each other. Thus, the integrated electronic component 220 being integrated in the front side 211 of the ASIC substrate 210 can be positioned as close as possible to the membrane structure 120. In some embodiments, the integrated electronic component 220 is positioned directly adjacent to the membrane structure 120, i.e., without any further electronic components sitting in between (except for the connection 221). Accordingly, the physical electric connection 221 can be made significantly shorter than a via being needed in conventional approaches, as described above. Therefore, the parasitic capacitance is significantly smaller and, thus, the undesired RF influences can be significantly reduced. In consequence, this leads to less crosstalk and noise and, thus, the SNR (Signal-to-Noise Ratio) can be increased.

The integration of the electronic component 220 in the front side 211 of the ASIC substrate 210 is possible because of the two-step cavity etch, wherein the smaller second cavity 160 faces the front side 211 of the ASIC substrate 210. The smaller second cavity 160 leaves enough space (i.e., a large enough bonding surface at the front side of the MEMS substrate 110) for bonding the respective front sides 111, 211 of the MEMS substrate 110 and the ASIC substrate 210 despite the electronic component 220 being integrated in the front side 211 of the ASIC substrate 210.

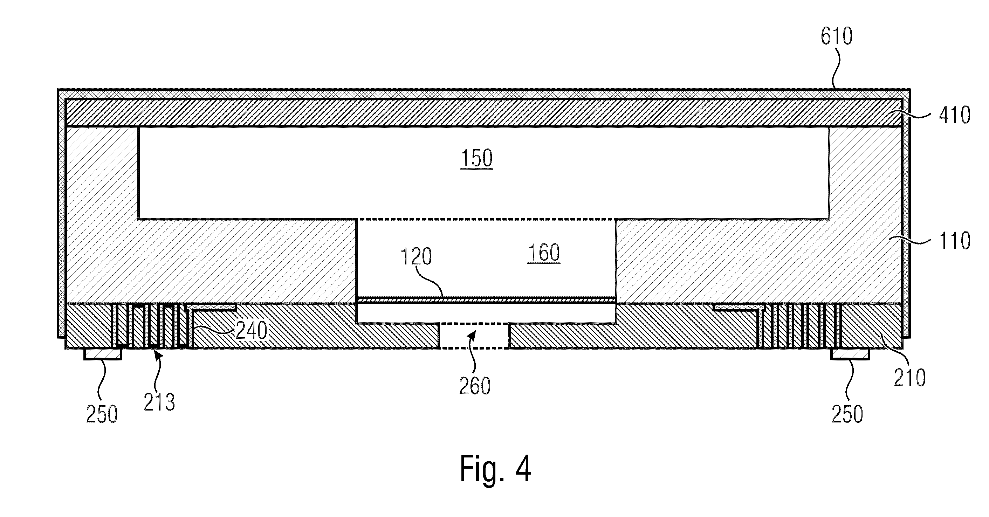

Figure 4 shows a further embodiment, wherein features with like structures and/or functions are labelled with like reference numerals. The above discussed integrated electronic component is not shown here for ease of illustration. This embodiment may differ from the other embodiments by having an optional RF shielding structure 213, which can, however, be applied to each and every embodiment discussed herein.

As can be seen in Figure 4, the innovative method may comprise a step of creating a plurality of interconnected through-substrate vias 240 in the ASIC substrate 210, said plurality of interconnected through-substrate vias 240 together form a radio frequency shielding structure 213. For example, the plurality of interconnected through-substrate vias 240 may together form a solenoid structure.

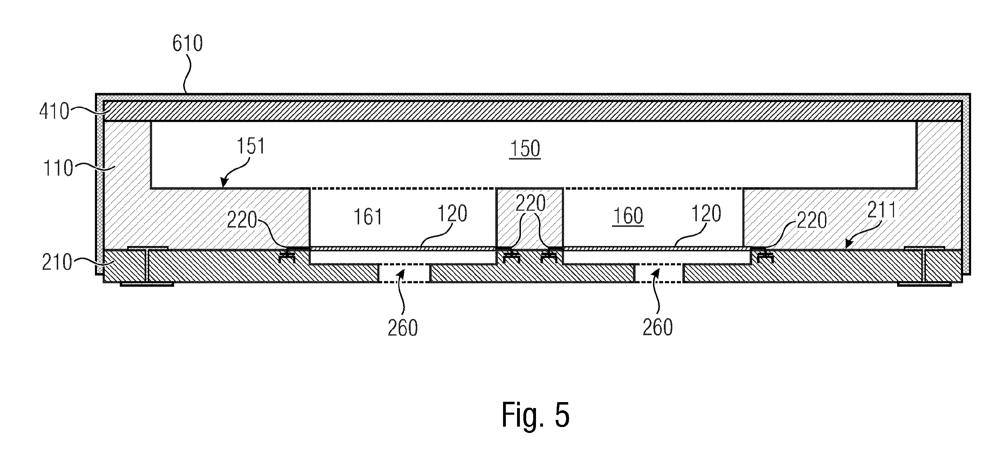

Figure 5 shows a further embodiment, wherein features with like structures and/or functions are labelled with like reference numerals. This embodiment may differ from the other embodiments by having two smaller cavities 160, 161, which can, however, be applied to each and every embodiment discussed herein.

According to this embodiment, the method may comprise a step of structuring at least one further second cavity 161 into the larger first cavity 150, in the same or similar way as described above with reference to the smaller second cavity labelled with reference numeral 160. In particular, the larger first cavity 150 may be structured with a predefined depth into the MEMS wafer 110 such that a bottom portion 151 of the first cavity 150 is created inside the MEMS wafer 110. The smaller second cavities 160, 161 may then be structured into said bottom portion 151 of the larger first cavity 150. The terms smaller and larger refer to the lateral extension of the cavities 150, 160, 161, i.e., their length, width or diameter (in case of circular cavities).

As can be seen, said further smaller second cavity 161 may be located (vertically) opposite to at least a second one of the plurality of adjacently arranged MEMS membrane structures 120, as discussed previously with reference to Figures 2A to 2H. Accordingly, said second MEMS membrane structure 120 may be released in the same or similar way as discussed above, for instance by removing the embedding material layer 130 through said further smaller second cavity 161.

Each MEMS membrane structure 120 may be electrically connected to an own integrated electronic component 220 being integrated in the first side 211 of the ASIC substrate 210. For example, the second MEMS membrane structure 120 provided in said further smaller second cavity 161 may be used as a noise cancellation device.

The larger first cavity 150 may provide a combined back volume for both membranes 120. More particular, the larger first cavity 150 and both of the smaller second cavities 160, 161 together form the back volume of the Wafer-Level Chip-Scale Package 100.

The back volume plays an important role for MEMS pressure transducers, for instance, for MEMS microphones of MEMS speakers. The larger the back volume, the better the SNR and the higher the performance of the MEMS device.

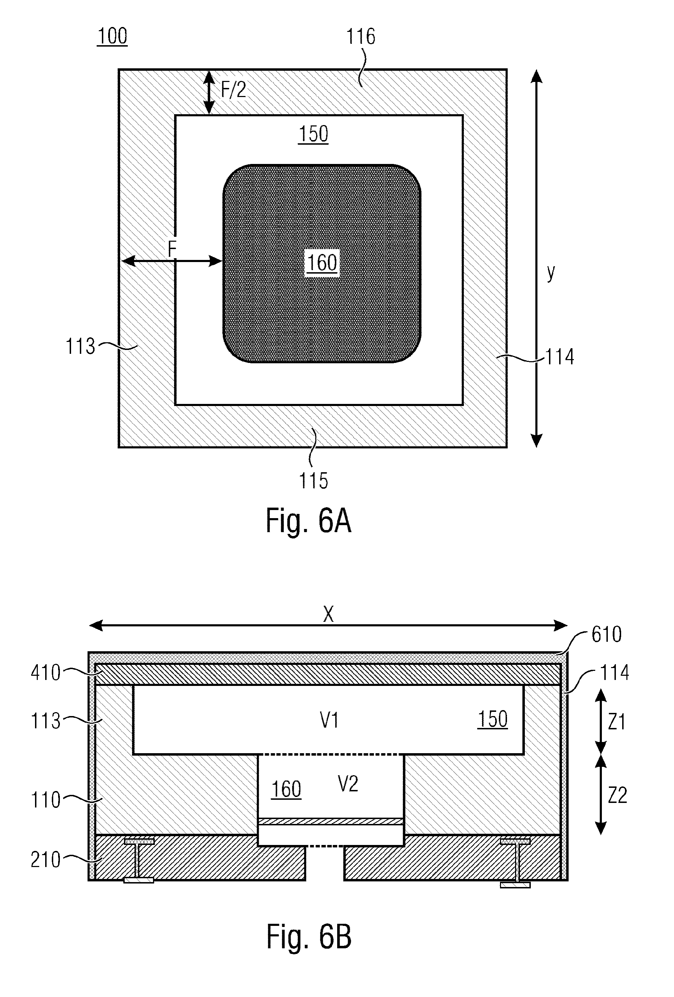

Figures 6A and 6B show examples of calculating the back volume, wherein Figure 6A shows a top view onto a Wafer-Level Chip-Scale Package 100 and Figure 6B shows a side view of the Wafer-Level Chip-Scale Package 100.

The lateral side walls 113, ..., 116 of the MEMS substrate 110 marking the outer circumferential border of the larger first cavity 150 have a thickness $\frac{1}{2}$ F. The outer circumferential border of the smaller second cavity 160 is spaced apart by a distance F from the outer surface of the lateral side walls 113, ..., 116 of the MEMS substrate 110. The Wafer-Level Chip-Scale Package 100 has a length y and a width x. The height of the larger first cavity 150 is denoted with z1. The height of the smaller second cavity 160 is denoted with z2. The volume of the larger first cavity 150 is denoted with V1. The volume of the smaller second cavity 160 is denoted with V2.

Accordingly, the back volume $V_{back}$ can be calculated as follows:

$$V1 = (x-F) * (y-F) * z1$$

$$V2 = (x-2F) * (y-2F) * z2$$

$$V_{back} = V1 + V2$$

For x=y:

$$V_{back} = (x-F)^2 * z1 + (x-2F)^2 * z2$$

While the above example is given for a single smaller second cavity 160, the calculations of V2 are the same for each further smaller second cavity, such as cavity 161.

In the following, two comparative examples in numbers shall be given, wherein the first example has:

x = y = 1.7 mm
F = 0.2 mm
z1 = 0.5 mm
z2 = 0.3 mm

$$V_{back} = (1.5 \text{ mm})^2 * 0.5 \text{ mm} + (1.3 \text{ mm})^2 * 0.3 \text{ mm}$$

$$= 1.125 \text{ mm}^3 + 0.507 \text{ mm}^3$$

$$= 1.63 \text{mm}^3$$

This first example has an SNR of 72.2 dB.

The second comparative example is given as:

x = y = 1.85 mm
F = 0.2 mm
z1 = 0.65 mm
z2 = 0.15 mm

$$V_{back} = (1.625\ mm)^2 * 0.65\ mm + (1.425\ mm)^2 * 0.15\ mm$$

$$= 1.716\ mm^3 + 0.305\ mm^3$$

$$= 2.02\ mm^3$$

This second example has an SNR of 73.5 dB.

For all embodiments discussed herein, it is possible to provide further structural components, such as an environmental barrier structure being attached to the back side 212 of the ASIC Wafer 210, such that the environmental barrier structure covers the opening 260.

Summarizing, the present disclosure concerns a structure with stacked ASIC 210, MEMS 110 and lid 410, with TSV connection 240 to MEMS 110 and ASIC 210. Metallizations 140, with solderable pads 250 attached to the second end of the TSVs 240 at the backside 212 of the ASIC 210. Optionally, a conductive layer 610 may cover all surfaces outside the solderable pads plane that is electrically connected to GND-pad. Inductors 213 may be realized by TSVs 240 in the ASIC 210 for RF suppression.

The front side 111 of the MEMS 110 may be wafer-bonded to the front side 211 of the ASIC 210 including metal interconnects. The ASIC backside 212 may be grinded. TSV 240 and pads 250 may be applied, a release etch for releasing the membrane 120 may be performed, and a lid 410 may be bonded to the back side 112 of the MEMS 110.

The innovative process can be done with at least one die to wafer bonding instead wafer-to-wafer bonding. An additional waferbonding can be applied for adding an environmental barrier and/or mesh. An additional waferbonding can be done for IPD for RFI suppression. Other sensor elements may be provided in the bonded stack.

For example, the innovative method may be used for manufacturing a silicon microphone 100 with a stacked MEMS 110 and ASIC 210 (frontside to frontside, backvolume included in MEMS 110), a lid 410 on MEMS backside 112 closing the backvolume and electrical through contacts 240 through the thinned ASIC 210 which connect ASIC 210 and MEMS 110 to Pads 250.

Inductors 213 may be realized as a 3D solenoid structure with TSV and frontside/backside metal of the ASIC 210.

In the following, some examples of embodiments regarding the MEMS pressure transducer Wafer-Level Chip-Scale Package (100) shall be given, which is obtainable by the herein described innovative method.

According to a first embodiment, the MEMS pressure transducer Wafer-Level Chip-Scale Package (100) comprises:

a substrate stack comprising at least MEMS substrate (110) and an ASIC substrate (210),

wherein the MEMS substrate (110) has a front side (111) and an opposite back side (112), wherein at least one MEMS membrane structure (120) is provided at the front side (111),

wherein the ASIC substrate (210) has a front side (211) and an opposite back side (212), the front side (211) comprising at least one integrated electronic component (220) for transducing an oscillation of the MEMS membrane structure (120) into an electric signal,

wherein the MEMS substrate (110) and the ASIC substrate (210) are stacked with their respective front sides (111, 211) facing each other,

a first cavity (150) provided in the backside (112) of the MEMS substrate (110) and a smaller second cavity (160) being located between the first cavity (150) and the front side (111) of the MEMS substrate (110),
wherein the MEMS membrane structure (120) is provided opposite said smaller second cavity (160), and

a lid (410) being bonded onto the backside (112) of the MEMS substrate (110) for covering the first cavity (150).

According to a second embodiment being combinable with the first embodiment,
the at least one integrated electronic component (220) may be located laterally adjacent to the MEMS membrane structure (120).

According to a third embodiment being combinable with the first or second embodiment,
the at least one integrated electronic component (220) may be galvanically connected at the frontside (211) of the ASIC substrate (210) with the MEMS membrane structure (120).

According to a fourth embodiment being combinable with one of the preceding embodiments,
the at least one integrated electronic component (220) may be a first amplifier transistor being directly connected to the MEMS membrane structure (120).

According to a fifth embodiment being combinable with one of the preceding embodiments,

the smaller second cavity (160) may comprise lateral dimensions being substantially equal to the lateral dimensions of the MEMS membrane structure (120), such that the MEMS membrane structure (120) fits into the smaller second cavity when being deflected, and

the first cavity (150) and the smaller second cavity (160) may together define a back volume of the MEMS pressure transducer Wafer-Level Chip-Scale Package (100).

According to a sixth embodiment being combinable with one of the preceding embodiments,

the ASIC substrate (210) may comprise a third cavity (230) provided in the front side (211) of the ASIC substrate (210), and

the third cavity (230) in the ASIC substrate (210) may be located opposite to the MEMS membrane structure (120) in the MEMS substrate (110).

According to a seventh embodiment being combinable with the sixth embodiment,

the ASIC substrate (210) may comprise an opening (260) being provided in the back side (212) of the ASIC substrate (210),

wherein the opening (260) may extend into the third cavity (230) for providing a port to the environment of the MEMS pressure transducer Wafer-Level Chip-Scale Package (100).

According to an eighth embodiment being combinable with the seventh embodiment,
the MEMS pressure transducer Wafer-Level Chip-Scale Package (100) may further comprise an environmental barrier structure provided at the back side (212) of the ASIC substrate (210) and covering the opening (260).

According to a ninth embodiment being combinable with one of the preceding embodiments,
the MEMS substrate (110) and the ASIC substrate (210) may be hybrid bonded with each other.

According to a tenth embodiment being combinable with one of the preceding embodiments,

the MEMS pressure transducer Wafer-Level Chip-Scale Package (100) may further comprise a metallization (140) provided between the front side (111) of the MEMS substrate (110) and the front side (211) of the ASIC substrate (210), said metallization (140) for electrically contacting the at least one integrated electronic component (220), and

the ASIC substrate (212) may comprise a through-substrate via (240) extending between the metallization (140) and a bond pad (250) provided on the back side (212) of the ASIC substrate (210).

According to an eleventh embodiment being combinable with one of the preceding embodiments,
the ASIC substrate (210) may comprise a plurality of interconnected through-substrate vias (240), wherein said plurality of interconnected through-substrate vias (240) together form a radio frequency shielding structure (213).

According to a twelfth embodiment being combinable with the eleventh embodiment,
the plurality of interconnected through-substrate vias (240) may together form a solenoid structure.

According to a thirteenth embodiment being combinable with one of the preceding embodiments,
the MEMS pressure transducer Wafer-Level Chip-Scale Package (100) may further comprise an electrically conductive coating (610) covering the entire MEMS pressure transducer Wafer-Level Chip-Scale Package (100) except the back side (212) of the ASIC substrate (210) for providing a radio frequency shielding.

According to a fourteenth embodiment being combinable with one of the preceding embodiments,

the MEMS pressure transducer Wafer-Level Chip-Scale Package (100) may further comprise a second MEMS membrane structure (120) provided at the front side (111) of the MEMS substrate (110), and

a further smaller second cavity (161) being located between the first cavity (150) and the front side (111) of the MEMS substrate (110),

wherein the second MEMS membrane structure (120) may be located opposite said further smaller second cavity (161).

According to a fifteenth embodiment being combinable with the fourteenth embodiment, the smaller second cavity (160) and the further smaller second cavity (161) may be positioned laterally adjacent to each other.

According to a sixteenth embodiment being combinable with one of the fourteenth or fifteenth embodiment, the first cavity (150) and the smaller second cavity (160) and the further smaller second cavity (161) may together define a back volume of the MEMS pressure transducer Wafer-Level Chip-Scale Package (100).

While this disclosure has been described with reference to illustrative embodiments, this description is not intended to be construed in a limiting sense. Various modifications and combinations of the illustrative embodiments, as well as other embodiments of this disclosure, will be apparent to persons skilled in the art upon reference to the description. It is therefore intended that the appended claims encompass any such modifications or embodiments.

## Claims

1. A method for manufacturing a MEMS pressure transducer Wafer-Level Chip-Scale Package (100), the method comprising:

   providing a MEMS wafer (110) having a front side (111) and an opposite back side (112), the front side (111) comprising a plurality of adjacently arranged MEMS membrane structures (120) being embedded in an embedding material layer (130),
   providing an ASIC wafer (210) having a front side (211) and an opposite back side (212), the front side (211) comprising a plurality of adjacently arranged integrated electronic components (220) for transducing a membrane oscillation into an electric signal,
   bonding the MEMS wafer (110) with the ASIC wafer (210) with their respective front sides (111, 211) facing each other,
   structuring at least one first cavity (150) into the backside (112) of the MEMS wafer (110) and structuring a smaller second cavity (160) into the first cavity (150), said smaller second cavity (160) being positioned opposite of at least one of the plurality of adjacently arranged MEMS membrane structures (120),
   releasing said at least one MEMS membrane structure (120) by removing the embedding material layer (130) through the second cavity (160),
   providing a lid wafer (410) and bonding said lid wafer (410) onto the back side (112) of the MEMS wafer (110) for covering the first cavity (150), and
   singulating the MEMS pressure transducer Wafer-Level Chip-Scale Package (100) by dicing around the covered first cavity (150).

2. The method of claim 1,
   wherein at least one of the plurality of adjacently arranged integrated electronic components (220) is located laterally adjacent to said at least one MEMS membrane structure (120).

3. The method of claim 1 or 2,
   wherein the at least one of the plurality of adjacently arranged integrated electronic components (220) is galvanically connected at the frontside of the ASIC wafer (210) with said at least one MEMS membrane structure (120).

4. The method of any one of the preceding claims,
   wherein the at least one integrated electronic component (220) is a first amplifier transistor being directly connected to the MEMS membrane structure (120).

5. The method of any one of the preceding claims,

   wherein the step of structuring the smaller second cavity (160) into the first cavity (150) comprises

structuring the second cavity (160) such that it comprises lateral dimensions being substantially equal to the lateral dimensions of the at least one MEMS membrane structure (120), such that the at least one MEMS membrane structure (120) fits into the second cavity (160) when being deflected, and

wherein the first cavity (150) and the second cavity (160) together define a back volume of the singulated MEMS pressure transducer Wafer-Level Chip-Scale Package (100).

6. The method of any one of the preceding claims, further comprising a step of

structuring at least one third cavity (230) into the front side (211) of the ASIC wafer (210) prior to bonding the ASIC wafer (210) with the MEMS wafer (110),

and bonding the ASIC wafer (210) with the MEMS wafer (110) such that the at least one third cavity (230) is positioned opposite to the at least one MEMS membrane structure (120).

7. The method of claim 6, further comprising a step of

structuring an opening (260) into the back side (212) of the ASIC Wafer (210),

wherein the opening (260) extends into the third cavity (230) for providing a port to the environment of the singulated MEMS pressure transducer Wafer-Level Chip-Scale Package (100).

8. The method of claim 7, further comprising a step of attaching an environmental barrier structure to the back side (212) of the ASIC Wafer (210), such that the environmental barrier structure covers the opening (260).

9. The method of any one of the preceding claims, wherein the step of bonding the MEMS wafer (110) with the ASIC wafer (210) is executed by applying hybrid bonding using a copper metallization.

10. The method of any one of the preceding claims, further comprising a step of

providing a metallization (140) between the ASIC Wafer (210) and the MEMS Wafer (110), said metallization (140) for electrically contacting at least one of the plurality of integrated electronic components (220), and

creating at least one through-substrate via (240) extending between the metallization (140) and a bond pad (250) provided on the back side (212) of the ASIC Wafer (210).

11. The method of any one of the preceding claims, further comprising a step of creating a plurality of interconnected through-substrate vias (240) in the ASIC Wafer (210), said plurality of interconnected through-substrate vias (240) together form a radio frequency shielding structure (213).

12. The method of claim 11, wherein the plurality of interconnected through-substrate vias (240) together form a solenoid structure.

13. The method of any one of the preceding claims, further comprising a step of

providing an electrically conductive coating (610) after singulating the MEMS pressure transducer Wafer-Level Chip-Scale Package (100),

said electrically conductive coating (610) covering the singulated MEMS pressure transducer Wafer-Level Chip-Scale Package (100) with the exception of the back side (212) of the ASIC Wafer (210) for providing a radio frequency shielding.

14. The method of any one of the preceding claims, further comprising a step of grinding the back side (212) of the ASIC Wafer (210), after bonding the ASIC Wafer (210) with the MEMS Wafer (110), for thinning the ASIC Wafer (210).

15. The method of any one of the preceding claims, further comprising a step of

structuring at least one further smaller second cavity (161) into the first cavity (150), said at least one further smaller second cavity (161) being positioned opposite to at least a second one of the plurality of adjacently arranged MEMS membrane structures (120), and

releasing said second MEMS membrane structure (120) by removing the embedding material layer (130) through the at least one further smaller second cavity (161).

16. A MEMS pressure transducer Wafer-Level Chip-Scale Package (100) obtainable by a method according to any one of the preceding claims, the MEMS pressure transducer Wafer-Level Package (100) comprising:

a substrate stack comprising at least MEMS substrate (110) and an ASIC substrate (210),

wherein the MEMS substrate (110) has a front side (111) and an opposite back side (112), wherein at least one MEMS membrane structure (120) is provided at the front side (111), wherein the ASIC substrate (210) has a front side (211) and an opposite back side (212), the front side (211) comprising at least one integrated electronic component (220) for transducing an oscillation of the MEMS membrane structure (120) into an electric signal, wherein the MEMS substrate (110) and the ASIC substrate (210) are stacked with their respective front sides (111, 211) facing each other,

a first cavity (150) provided in the backside (112) of the MEMS substrate (110) and a smaller second cavity (160) being located between the first cavity (150) and the front side (111) of the MEMS substrate (110), wherein the MEMS membrane structure (120) is provided opposite said smaller second cavity (160), and a lid (410) being bonded onto the backside (112) of the MEMS substrate (110) for covering the first cavity (150).

11

12                                                                                      13

14

15                          16

                    17

                    18

                    19

# Fig. 1A

10

11                      12              13

14

17        18

# Fig. 1B

Fig. 2A

Fig. 2B

Fig. 2C

Fig. 2D

Fig. 2E

Fig. 2F

Fig. 2G

Fig. 2H

EP 4 717 664 A1

Fig. 3

Fig. 4

Fig. 5

EP 4 717 664 A1

Fig. 6A

Fig. 6B

**EUROPEAN SEARCH REPORT**

Application Number

EP 24 20 3229

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2016/031704 A1 (SHEN WEI-CHENG [TW] ET AL) 4 February 2016 (2016-02-04) | 1-4, 6-10, 13-16 | INV.<br>B81C1/00<br>H04R19/00 |
| A | * figures 1, 9, 26-31 * | 5,11,12 | |
| | ----- | | |
| Y | US 2015/102390 A1 (LIU FANG [US] ET AL) 16 April 2015 (2015-04-16) | 1-4, 6-10, 13-16 | |
| A | * figures 1,3,6A-6C * | 5,11,12 | |
| | ----- | | |
| A | US 2017/247248 A1 (HOEKSTRA TSJERK HANS [GB]) 31 August 2017 (2017-08-31)<br>* figures 3,4 * | 11,12 | |
| | ----- | | |
| A | US 2012/104629 A1 (BOLOGNIA DAVID [US] ET AL) 3 May 2012 (2012-05-03)<br>* figures 7A,7B * | 11,12 | |
| | ----- | | |
| A | US 2018/020275 A1 (LEE SUNG B [US] ET AL) 18 January 2018 (2018-01-18)<br>* figure 1 * | 1,13 | **TECHNICAL FIELDS SEARCHED (IPC)** |
| | ----- | | |
| A | DE 10 2014 118340 A1 (EPCOS AG [DE]) 16 June 2016 (2016-06-16)<br>* figure 21 * | 13 | B81C<br>H04S<br>B81B<br>H04R |
| | ----- | | |

The present search report has been drawn up for all claims

| Place of search | Date of completion of the search | Examiner |
|---|---|---|
| Berlin | 6 May 2025 | McGinley, Colm |

EPO FORM 1503 03.82 (P04C01)

Europäisches
Patentamt

European
Patent Office

Office européen
des brevets

**Application Number**

EP 24 20 3229

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**

**SHEET B**

The Search Division considers that the present European patent application does not comply with the requirements of unity of invention and relates to several inventions or groups of inventions, namely:

```
1. claims: 1-10, 14-16

   A wafer level package with a transducer membrane in an
   internal cavity where the placing of openings to the cavity
   are optimised to allow maximum deflection of the membrane.
                          ---

2. claims: 11-13

   A wafer level package with a transducer membrane in an
   internal cavity where the package includes conductive
   shielding against electromagnetic waves.
                          ---
```

## ANNEX TO THE EUROPEAN SEARCH REPORT
## ON EUROPEAN PATENT APPLICATION NO.

EP 24 20 3229

This annex lists the patent family members relating to the patent documents cited in the above-mentioned European search report.
The members are as contained in the European Patent Office EDP file on
The European Patent Office is in no way liable for these particulars which are merely given for the purpose of information.

06-05-2025

| Patent document cited in search report | Publication date | Patent family member(s) | Publication date |
|---|---|---|---|
| US 2016031704 A1 | 04-02-2016 | NONE | |
| US 2015102390 A1 | 16-04-2015 | CN 104581586 A | 29-04-2015 |
| | | EP 2863653 A1 | 22-04-2015 |
| | | KR 20150043993 A | 23-04-2015 |
| | | US 2015102390 A1 | 16-04-2015 |
| | | US 2016167956 A1 | 16-06-2016 |
| US 2017247248 A1 | 31-08-2017 | GB 2547729 A | 30-08-2017 |
| | | TW 201741226 A | 01-12-2017 |
| | | US 2017247248 A1 | 31-08-2017 |
| | | WO 2017149273 A1 | 08-09-2017 |
| US 2012104629 A1 | 03-05-2012 | US 8115283 B1 | 14-02-2012 |
| | | US 2012104629 A1 | 03-05-2012 |
| | | US 2015191346 A1 | 09-07-2015 |
| | | US 2016355395 A1 | 08-12-2016 |
| US 2018020275 A1 | 18-01-2018 | NONE | |
| DE 102014118340 A1 | 16-06-2016 | DE 102014118340 A1 | 16-06-2016 |
| | | WO 2016091592 A1 | 16-06-2016 |

EPO FORM P0459

For more details about this annex : see Official Journal of the European Patent Office, No. 12/82